# EUROPEAN PATENT APPLICATION

(11) **EP 1 217 663 A1**
(43) Date of publication of application: **26.06.2002**
(21) Application number: 00870312.6
(22) Date of filing: 21.12.2000
(51) Int. Cl.: H01L 31/18, H01L 21/18

(54) **A method of producing a semiconductor layer on a substrate**

(71) Applicant: Interuniversitair Micro-Elektronica Centrum, 3001 Heverlee (BE); Umicore S.A., 1000 Brussels (BE)
(72) Inventor: Poortmans, Jef, 3010 Leuven (BE); Flamand, Giovanni, 2110 Wijnegem (BE); Bilyalov, Renat, 3390 Tielt-Winge (BE)
(74) Representative: Van Malderen, Joelle

(57) **Abstract**

A method of producing a semiconductor layer onto a semiconductor substrate, comprising the steps of :
- Providing a first semiconductor substrate (1),
- Providing a second semiconductor substrate (5),
- Producing a porous layer (6,7,8) on top of said second semiconductor substrate, said layer having a porosity profile,
- Bringing said porous layer of said second substrate (5) into contact with said first substrate (1), so as to form a bond between said two substrates,
- Performing a thermal annealing step,
- Lifting off of said second substrate, leaving a layer of said second substrate's semiconductor material attached to said first substrate.

## Description

### Field of the invention

The present invention is related to a method of realising a bond between a substrate, preferably a Si-substrate and a thin semiconductor layer, such as a Ge layer. The present invention is equally related to products resulting from such a method.

### State of the art

Ge-substrates are often used as a substrate for the growth of active III-V devices (e.g. multijunction monolithic cascade solar cells or LED's). However, a Ge-substrate is much more expensive than a Si-substrate, and more importantly, Si has a much higher strength than Ge (by a factor of 2) and lower density.

Therefore, the realisation of a Ge-layer on a Si-substrate has gained a large importance for the production of opto-electronic applications.

The epitaxial growth of GaAs layers on Ge-substrates is known to give good results due to the good lattice match between these two materials. When it comes to growing Ge (or GaAs) layers on Si, however, problems occur due to a lattice mismatch of over 4% for both Ge and GaAs, compared to Si.

First of all, techniques are documented in the literature, to combine Si and GaAs.

Document US-A-4959308 describes a method of forming a GaAs layer on Si wherein a defect annihilating grid is formed on the Si substrate prior to the epitaxy of GaAs, in order to reduce the effects of lattice mismatch.

Known methods of producing GaAs layers on Si-substrates however do not allow to produce GaAs layers with defect densities lower than 10⁵-10⁶ cm⁻², which is still one order of magnitude too high to realise devices with a good energy conversion efficiency.

Document US-A-4806996 describes a device wherein an epitaxial layer, such as Ge or GaAs is formed on a single crystal substrate, such as a Si substrate, and wherein the surface of said substrate is suitably patterned in order to reduce lattice mismatch effects. The process required for producing said device is however complex and comprises many process steps.

Alternatively, methods have been reported of realising a graded layer of SiGe, which is rich in Si at the Si substrate and gradually becomes pure Ge near the top of the layer.

By the Ge-grading, the number of threading dislocations is kept low, because the misfit dislocations bend sidewards. The grading, which is optimally in the order of a change of 10% Ge per µm, is realised by adapting the growth parameters during growth. Growth of GaAs-layers on such graded buffer layers of Ge on Si has been realised and photoluminescence measurements give evidence of the good quality of the GaAs epitaxial layer.

A method of growing such a GexSi1-x layer on a Si substrate by molecular beam epitaxy is described in document US-A-4529455.

A drawback of this kind of graded layer is the cost of the process used, which is comparable to the cost of the Ge-substrate. This is a consequence of the growth procedure used.

### Aims of the invention

The method according to the present invention aims to provide a stable bond preferably between a semiconductor substrate and a semiconductor layer, without applying intermediate layers, patterning of the substrate or epitaxy of a graded layer.

### Summary of the invention

The present invention is related to a method of producing a semiconductor layer onto a semiconductor substrate, comprising the steps of :
- Providing a first semiconductor substrate,
- Providing a second semiconductor substrate,
- Producing a porous layer on top of said second semiconductor substrate, said layer having a porosity profile,
- Bringing said porous layer of said second substrate into contact with said first substrate, so as to form a bond between said two substrates,
- Performing a thermal annealing step,
- Lifting off said second substrate, leaving a layer of said second substrate's semiconductor material attached to said first substrate.

According to a preferred embodiment, the method of the invention further comprises the step of forming a porous layer on top of said first substrate, prior to the step of bringing said substrates into contact, said porous layer having a porosity profile, and wherein said two porous layers of said two substrates are brought into contact, so as to form a bond between said two substrates.

Said porosity profile of said second substrate may be formed by a first layer of high porosity adjacent to said second substrate's surface, followed by a second layer of lower porosity and a third layer of high porosity.

Said porosity profile of said first substrate is formed by a first layer of high porosity adjacent to said first substrate's surface, followed by a second layer of lower porosity.

According to a preferred embodiment, a layer of the material of said second substrate is formed on top of said first substrate, said layer comprising a number of voids.

Said first substrate may be a Si-substrate and said second substrate a Ge-substrate. Said first substrate may be a Si substrate and said second substrate a GaAs substrate. Both said first and said second substrates may be Si substrates.

Said forming of porous layers may be done by an anodisation step.

The method according to the invention may comprise the steps of :
- forming a porous layer on said second substrate through anodisation in a solution of HF and acetic acid,
- bringing said first substrate into contact with said second substrate while said second substrate is still in the solution used to perform said anodisation.

According to another embodiment, the method according to the invention comprises the steps of :
- forming a porous layer on said second substrate through anodisation in a solution of HF and acetic acid,
- removing said second substrate from said solution,
- bringing said first substrate into contact with said second substrate.

The present invention is equally related to a semiconductor device, produced with the method of the invention. Said device may be an opto-electronic device.

### Short description of the drawings

Fig. 1 illustrates the principle of the method according to the present invention.

Fig. 2 represents a substrate with a porosity profile along a curve.

### Detailed description of the invention

The present invention is related to a method of producing a thin layer of a first semiconductor material onto a substrate made of the same or another semiconductor material, by bringing two substrates of said respective materials into contact with each other. It is necessary that at least one of the substrates has a 'porosity profile' under its surface. In its simplest form, this profile is defined by a top layer having a given higher porosity than the substrate underneath said top layer. Other more complex profiles are possible, as set out further in this description. Preferably, both substrates have such a porosity profile. These two substrates are then brought into contact in such circumstances as to form a bond between said two substrates. It is then the phenomenon of lift-off, preferably spontaneous or mechanical lift-off, which causes one of the substrates to be removed, leaving a thin layer of said removed substrate's material attached to the other substrate. In terms of composition, grading, mechanical and other properties, the layer that is formed depends on the original porosity profiles of the two substrates, and on the process parameters (annealing temperatures, environment, etc...).

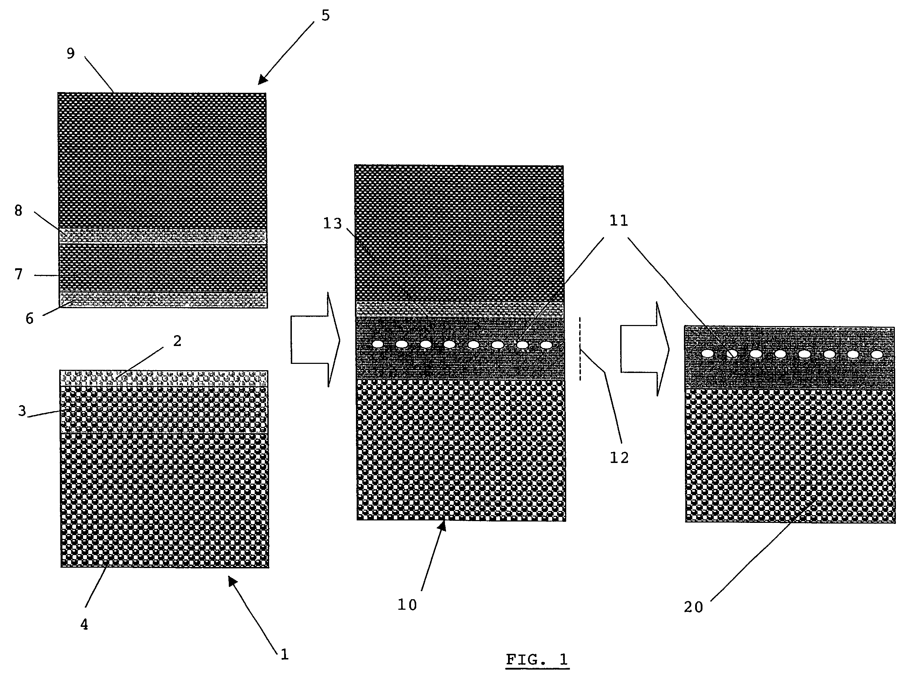

A schematic overview of a preferred embodiment of the method according to the invention is illustrated in figure 1. A silicon substrate 1 is provided, having a top layer 2 of high porosity, above a sublayer 3 of lower porosity and the base substrate 4, which has a higher porosity than both layers 2 and 3. Further, a Ge-substrate 5 is provided, having a top layer 6 with high porosity, a first sublayer 7 of lower porosity and a second sublayer 8 of high porosity adjacent to the base substrate 9, the latter having higher porosity than either of the layers 6,7 and 8. These substrates and their porosity profiles are produced according to any known method. The thickness of the porous layers (6+7+8) on the Ge-substrate preferably lies between 1µm and 5µm, that of the porous layer on the Si substrate (2+3) preferably lies between 2µm and 10µm. The porosity of the Ge-layers preferably lies between the following limits (expressed in % air, i.e. pores in a given volume of the layer) : 50-60% (layer 6), < 50% (layer 7), 60-70% (layer 8), 50-60% (layer 2), 20-40% (layer 3).

By bringing the two porous layers 2 and 6 in mutual contact, and by performing an annealing step to strengthen said contact, a bond is formed and the porous layers reorganise because of the enhanced diffusivity of Ge and Si atoms, during the thermal anneal. As a result, a structure 10 is formed. The low-porosity part of the Ge (layer 7) has grown more dense whereas the high porosity part of Si and Ge (layers 2 and 6) have merged through interdiffusion and formed buried voids 11.

Depending on the process parameters, this structure is such that the region 12, due to densifying and diffusion, essentially comprises pure Ge in its top section 13. Under this section, the composition then gradually changes to a Si₁₋ₓGeₓ composition, with a growing percentage of Si in layers approaching the Si substrate. In the section where the two original porous top layers made contact, interdiffusion of Si and Ge has now formed a series of voids 11, which are particularly advantageous for certain aspects of the invention, as will be explained later.

The production of the final device 20 occurs through the so-called 'lift-off' phenomenon. When the change in porosity is sufficiently large, spontaneous lifting-off of a porous layer from a substrate can occur. In the case of the structure 10, this phenomenon takes place when the top of region 12 has become sufficiently dense : at this point, the porous layer 8, along with the entire Ge-substrate is lifted off at section 13, resulting in the device 20. To have spontaneous lift-off, layer 8 must have sufficient porosity. If the porosity is lower than the required limit, mechanical lift-off may still be possible. This means that the breaking off of the Ge-layer is induced by a small mechanical force (for example exerted by a pair of tweezers). According to the invention, the thermal anneal may come before or after the lift-off, or both may occur essentially simultaneously as is illustrated further in this text in some preferred embodiments of the process steps of the method of the invention.

The resulting device 20 is characterised by a Si base substrate, pure Ge on top, and an intermediate Si₁₋ₓGeₓ layer having a graded composition and a number of voids 11. The number and size of said voids depends on the original porosity of the porous layers.

These voids have a double function. The first is to relieve the stresses resulting from the mismatch between the two materials and the second is to act as a buried reflector in between the two materials, which increases the energy conversion efficiency of solar cells or increases the emission efficiency of LED's.

In the case of Si-Ge bonds, the method of the invention allows to produce such devices at a considerably lower cost than existing methods, due to its economic use of Ge. In fact, a Ge substrate can be re-used several times after having been involved in the above described process. This way, one Ge-substrate may produce numerous thin Ge-layers.

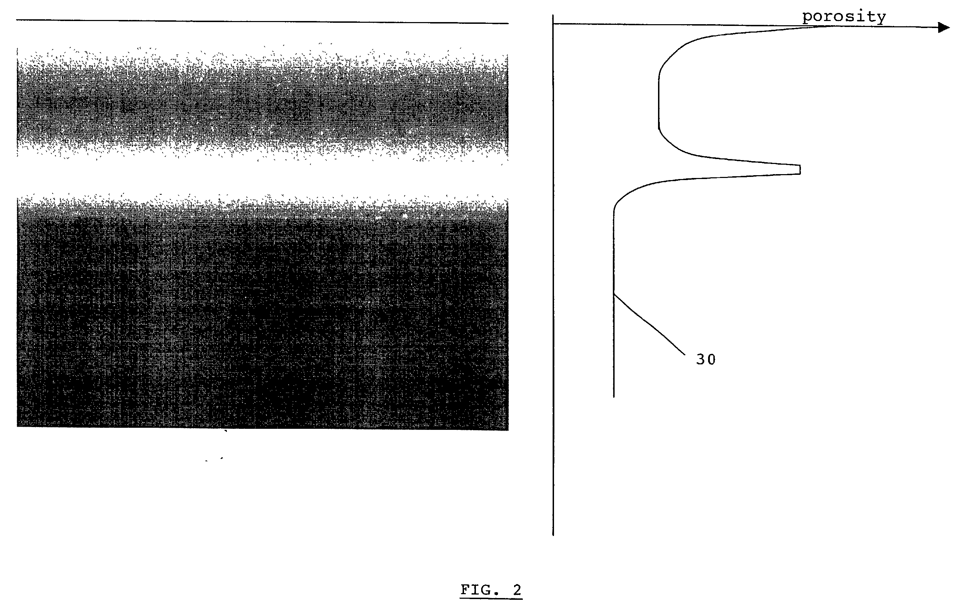

An important aspect of the present invention concerns the porosity profile in the two substrates which are brought together. As stated , the invention is not limited to substrates as shown in figure 1. In general, it is enough that at least one of the two substrates has a porosity profile. The double change in porosity as shown in the preferred embodiment of figure 1 is used to produce the graded Ge-layer described. Layers with other properties (not necessarily graded) are produced starting from substrates with other porosity profiles. Also, the transition between high porosity and low porosity zones need not be as discontinuous as in figure 1. Figure 2 shows a similar profile, wherein the change in porosity takes place along a continuous curve 30, as a function of depth.

The method of the invention is not limited to the forming of bonds between Si and Ge. Other bonds such as Si/Si and Si/GaAs can be produced by this method.

### Preferred embodiments of process steps according to the invention

According to a first preferred embodiment, the method of the invention comprises the following steps: Step 1 : Production of a Si substrate having a porous Si top layer, with the profile of figure 1.

A porous Si-film is created on top of the Si substrate by anodisation carried out in a conventional Teflon cell with a silicon sample as an anode and a platinum counter electrode as a cathode. The solution of HF and acetic acid is used as an electrolyte. The concentration of HF in acetic acid is chosen higher than 20% to form a low porosity layer at a current density of more than 100mA/cm², which provides a high electro-chemical etching rate. A layer of different porosity can be formed by changing the current density and/or by changing the HF concentration in the solution. The electrochemical etching is carried out at room temperature and background illumination.

### Step 2 : production of the Ge-substrate with porosity profile as in fig. 1.

The porous Ge-layer is realised on a p-type Ge-substrate, having a doping level in the range from 10¹⁵ to 10¹⁷ cm⁻³. The porous Ge-layer is realised by anodisation in a Teflon Cell. The composition of the mixture is as follows: 1 part HF (49% in H₂O)/1 part H₂O/2 parts ethanol. The window to realise such layer is narrow and small deviations of the concentrations mentioned (about 10%) results in rough layers or electropolishing. After an incubation period in which electropolishing occurs which removes about 10 µm of Ge, a porous Ge-layer is being formed. By simultaneous etching of the top surface and further progress of the porous Ge/Ge interface, the thickness of the porous layer is limited to about 2 µm. When a similar porous layer is created on an n-type Ge-substrate, having a doping level between 5x10¹⁶ and 5x10¹⁷ cm⁻³, the porous Ge is created in a mixture which is the same as above, but the allowable deviations of the composition are much larger. The layer created contains macroporous material, which does not lift-off as such.

### Step 3 : bringing the two substrates in contact

By putting a Si-piece with the surface made porous on top of the porous Ge- surface with the Ge-sample still in the solution, curling-up of the Ge-film can be avoided and the Ge-film transferred to the Si-surface. The porosity gradient in the layer is created simultaneously with the formation. The average porosity of the thus formed layer is between 25 and 40%.

### Step 4 : removing the substrates from the solution and causing lift-off of the Ge-layer from the Si-substrate.

Depending on the porosity of layer 8 in the Ge-substrate, this lift-off will be spontaneous or mechanical.

### Step 5 : thermal anneal

This is typically done at temperatures between 900°C and 1050°C in a non-oxidising atmosphere, such as H2. During this step, the porous layers reorganise because of the enhanced diffusivity of Ge and Si atoms. As a result, the low-porosity part of the Ge (layer 6) will densify whereas the high porosity part of Si and Ge will interdiffuse and form buried voids.

The order of the thermal anneal step and the lift-off step may be reversed, or both steps may take place simultaneously.

According to a second preferred embodiment, the steps 1 and 2 are the same, but the Ge-substrate is first removed from the solution and then brought into contact with the Si-substrate, after which thermal anneal and lift-off are performed.

Other embodiments of the invention depend on the exact porosity profiles of both substrates. For example, if the Si-substrate has a similar profile than the Ge-substrate (see fig. 1), lift-off will occur both of the Ge-substrate and the Si-substrate, leaving a thin Si-Ge film as the resulting product.

## Claims

1. A method of producing a semiconductor layer onto a semiconductor substrate, comprising the steps of :
- Providing a first semiconductor substrate (1),
- Providing a second semiconductor substrate (5),
- Producing a porous layer (6,7,8) on top of said second semiconductor substrate, said layer having a porosity profile,
- Bringing said porous layer of said second substrate (5) into contact with said first substrate (1), so as to form a bond between said two substrates,
- Performing a thermal annealing step,
- Lifting off said second substrate, leaving a layer of said second substrate's semiconductor material attached to said first substrate.

2. Method according to claim 1, further comprising the step of forming a porous layer (2,3) on top of said first substrate (1), prior to the step of bringing said substrates into contact, said porous layer having a porosity profile, and wherein said two porous layers of said two substrates are brought into contact, so as to form a bond between said two substrates.

3. A method according to claim 1 or 2 wherein said porosity profile of said second substrate is formed by a first layer (6) of high porosity adjacent to said second substrate's surface, followed by a second layer (7) of lower porosity and a third layer (8) of high porosity.

4. A method according to claims 2 or 3, wherein said porosity profile of said first substrate is formed by a first layer (2) of high porosity adjacent to said first substrate's surface, followed by a second layer (3) of lower porosity.

5. A method according to any one of the preceding claims, wherein a layer of the material of said second substrate is formed on top of said first substrate, said layer comprising a number of voids (11).

6. Method according to any one of the preceding claims, wherein said first substrate is a Si-substrate and said second substrate is a Ge-substrate.

7. Method according to any one of the preceding claims, wherein said first substrate is a Si substrate and said second substrate is a GaAs substrate.

8. Method according to any one of the preceding claims, wherein both said first and said second substrates are Si substrates.

9. Method according to any one of the preceding claims, wherein said forming of porous layers is done by an anodisation step.

10. Method according to claim 9, comprising the steps of :
- forming a porous layer on said second substrate through anodisation in a solution of HF and acetic acid,
- bringing said first substrate into contact with said second substrate while said second substrate is still in the solution used to perform said anodisation.

11. A method according to claim 9, comprising the steps of :
- forming a porous layer on said second substrate through anodisation in a solution of HF and acetic acid,
- removing said second substrate from said solution,
- bringing said first substrate into contact with said second substrate.

12. A semiconductor device, produced with the method of claims 1 to 11.

13. A device according to claim 12, wherein said device is an opto-electronic device.
